# EUROPEAN PATENT APPLICATION

(11) **EP 2 048 789 A1**
(43) Date of publication of application: **15.04.2009**
(21) Application number: 07017990.8
(22) Date of filing: 13.09.2007
(51) Int. Cl.: H03M 13/27

(54) **Convolutional interleaving of variable bit-rate data streams**

(71) Applicant: Panasonic Corporation, Kadoma-shi Osaka 571-8501 (JP)
(72) Inventor: Petrov, Mihail, 63225 Langen (DE); Kursawe, Thomas, 63225 Langen (DE)
(74) Representative: Grünecker, Kinkeldey, Stockmair & Schwanhäusser Anwaltssozietät

(57) **Abstract**

The present invention discloses a method and a corresponding apparatus for interleaving variable-bit-rate data streams by mapping variable-size data blocks, each obtained within one frame, to fixed-size frame blocks that consists of a larger or equal number of words. The resulting frame blocks may then be subjected to convolutional interleaving. The algorithm ensures that the data words are distributed as evenly as possible over the entire frame in order to maximize time diversity.

## Description

The present invention relates to OFDM (orthogonal frequency-division multiplexing) communication systems, and in particular to a method and a corresponding apparatus for mapping a plurality of data words on a frame that consists of a larger or equal number of words so that the plurality of data words can be interleaved by means of a conventional convolutional interleaver.

### BACKGROUND OF THE INVENTION

Orthogonal Frequency-Division Multiplexing (OFDM) is a digital multi-carrier modulation scheme, which uses a large number of closely-spaced orthogonal sub-carriers. Each sub-carrier is modulated with a conventional modulation scheme (such as quadrature amplitude modulation) at a low symbol rate, maintaining data rates similar to conventional single-carrier modulation schemes in the same bandwidth.

The primary advantage of OFDM over single-carrier schemes is its ability to cope with severe channel conditions - for example, attenuation of high frequencies at a long copper wire, narrowband interference and frequency-selective fading due to multipath - without complex equalization filters. Channel equalization is simplified because OFDM may be viewed as using many slowly-modulated narrowband signals rather than one rapidly-modulated wideband signal. Low symbol rate makes the use of a guard interval between symbols affordable, making it possible to handle time-spreading and eliminate inter-symbol interference.

OFDM has developed into a popular scheme for wideband digital communication systems, including the new DVB-T2 (Next Generation DVB-T, digital video broadcasting - terrestrial) standard. In an OFDM communication system, a constant-capacity channel carries multiple variable-bit-rate data streams (services). The OFDM stream is divided into frames of constant duration, which contain a fixed number of OFDM cells. An OFDM cell is defined as the complex data carried on a certain subcarrier for a given OFDM symbol.

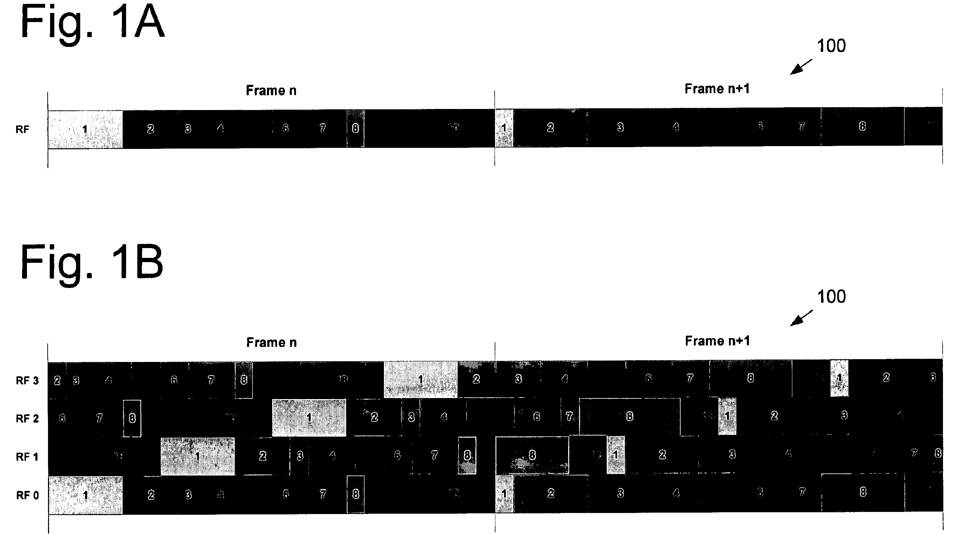

The multiplexing of the service data (1-10) onto an OFDM frame (100) is performed using time slicing (TS) when only one radio frequency channel (RF) is available, as in Figure 1A, or time-frequency slicing (TFS) when multiple radio frequency channels (RF0-RF3) are available, as in Figure 1B. In both cases, the contiguous data blocks belonging to a service are referred to as slots. In the TFS case, each service (1-10) is spread over the whole frame (100), which increases the robustness against Rayleigh channel fading.

The main idea is that a given number variable-bit-rate services are mapped on a constant-capacity channel. As the allocation unit is one OFDM frame, the slot allocation will typically change on a frame-by-frame basis, following the bit-rate variations of the individual services. Of course, the system design must guarantee that for any frame, the number of OFDM cells for all services does not exceed the channel capacity, expressed as the number of OFDM cells in the OFDM frame.

In OFDM, the channel transfer function (CTF) changes along both the subcarrier and the symbol axis. This phenomenon is referred to as frequency/time diversity. In order to ensure maximum performance, each service data must undergo interleaving before being mapped onto the OFDM frame, so that a deep fading (strong destructive interference due to multipath) in the CTF is spread as widely as possible. For maximum performance, the interleaving should be performed over the whole frame (all slots), for each service.

Two types of interleavers are known in the art: block and convolutional interleavers. The former interleaves data on a block-by-block basis; whereas the latter spreads an input block over two output blocks. The essential advantage of the convolutional interleaver is the memory requirements. For a smooth (non burst) data flow at input and output, a block interleaver needs twice the block size, while a convolutional one only half of it.

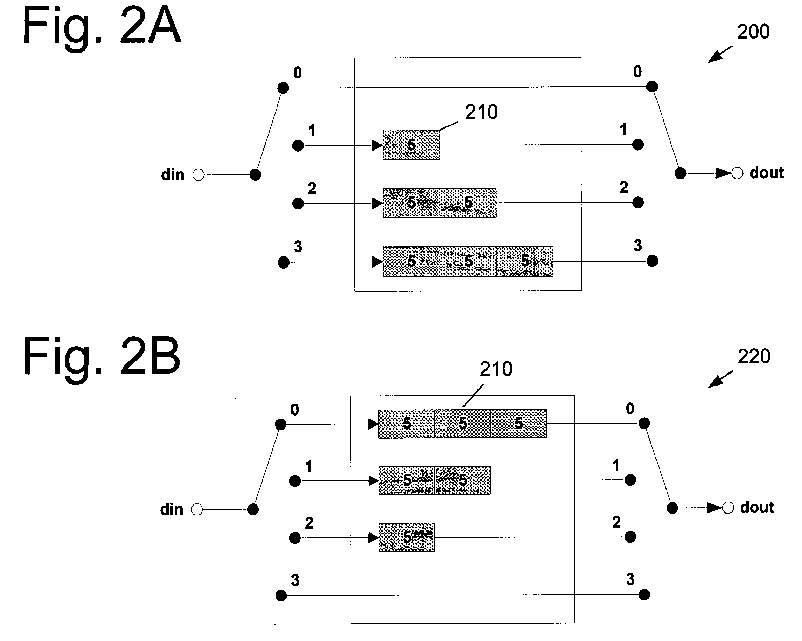

Figure 2A and Figure 2B show the schematic of a convolutional interleaver (200) and deinterleaver (220), respectively. The interleaver (200) consists of K branches (0, ..., 3), each branch having a k*D delay, where D is the elementary delay (210) and k is the branch index from 0 to K-1. In the deinterleaver (220), the branch order is reversed. It is essential that the deinterleaver be synchronized with the interleaver.

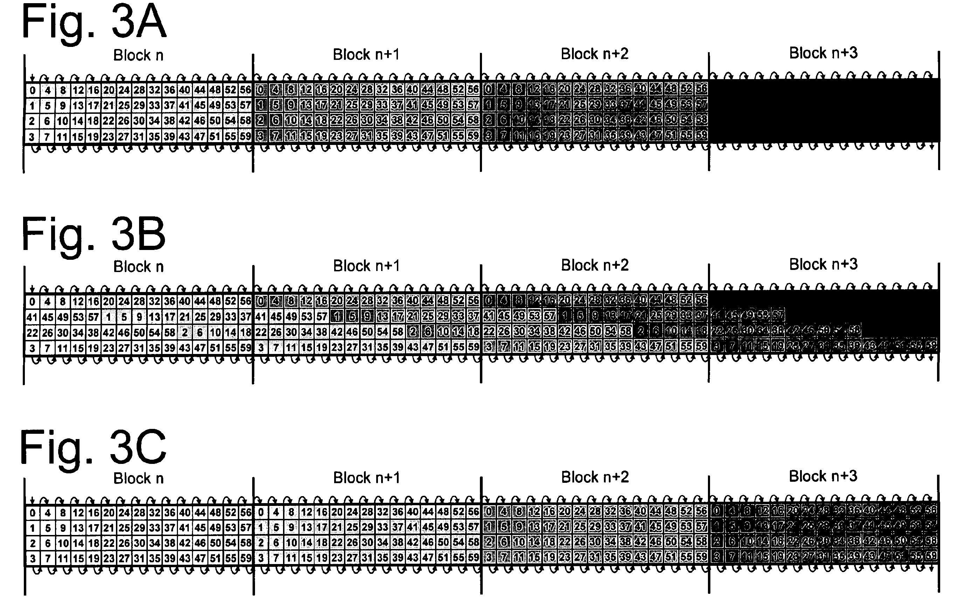

For a given K and D, the resulting block size is K*(K-1)*D. In the above mentioned pictures, K = 4 and D = 5, which results in a block size of 60. For a better intuitive understanding, Figure 3 shows the interleaving and deinterleaving process: Fig. 3A is the input data, Fig. 3B is the interleaved data, and Fig. 3C is the deinterleaved data. After interleaving, each input block is spread over two output blocks in a helical fashion. The end-to-end algorithmic delay is exactly one block.

The above discussion assumed a constant rate of the data stream. For variable-data-rate services, however, convolutional interleaving can no longer be used directly. In the considered OFDM system, convolutional interleaving is applied at frame level; therefore the block size depends on the amount of service data per frame, which is variable. In order to use convolutional interleaving, a constant block size is needed.

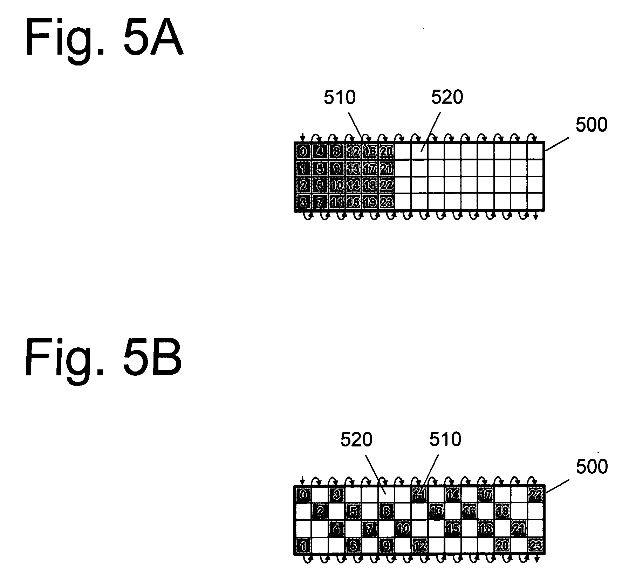

The conventional solution to this problem is illustrated in Fig. 5A, which is a schematic drawing of a exemplary frame block (500) consisting of 60 frame words on which 24 data words (shaded squares, 510) have been mapped. The data words are followed by 36 dummy words (open squares, 520), which have been appended at the end of the data block. According to this solution, a larger and constant block size is used and a variable number of dummy data words is appended at the end of the data block to fill the space. Obviously, the block size must be chosen so that it accommodates at least the peak data rate of the service. With this solution the end-to-end delay of the whole chain is independent of the actual data rate of the service.

The conventional solution, however, has the disadvantage, that the data words after interleaving are not spread over two full frames but tend to concentrate in their current frame only, leading to a loss of time diversity.

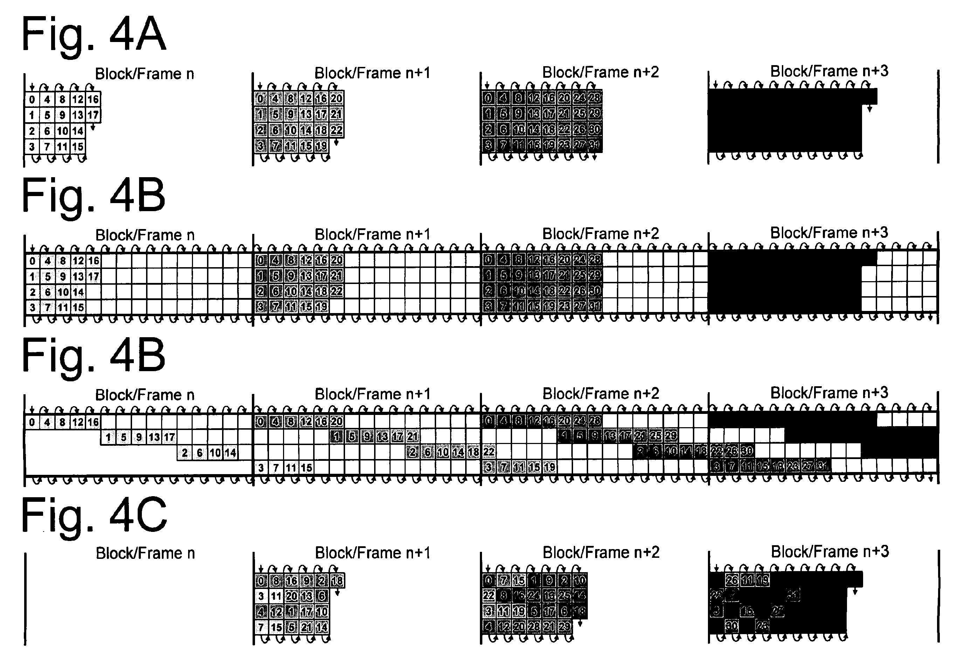

This problem is readily apparent from Fig. 4, which illustrates the interleaving process for a variable-rate service and a block size of 60 words, corresponding to the interleaver of Figure 2A. In Fig. 4A, four variable-size data blocks are shown, consisting of 18, 23, 32, and 41 words respectively. Each of these blocks contains the data generated by the service during the corresponding frame. In Fig. 4B a variable number of dummy words is appended after the data block in order to achieve the interleaving block size, i.e. 60 in our example. The resulting blocks are then interleaved (Fig. 4C) and the dummy words are removed (Fig. 4D). The insertion and removal of dummy words does not need to be physical, as this would increase the memory and throughput requirements. Regardless of the actual implementation, the resulting data will look like in Fig. 4D.

The problem of loss of time diversity is most severe for small ratios between the number of data words and the number of total words in a frame block. The worst case is when the diversity is reduced to a single frame only, which happens for very low data rates. This is extremely inconvenient because the full time diversity over two frames cannot be exploited.

### SUMMARY OF THE INVENTION

It is thus the aim of the present invention to provide an improved method for convolutional interleaving of variable-bit-rate streams and a corresponding apparatus. It is a further aim of the present invention to provide a method and a corresponding apparatus for inserting dummy words in a data block and for mapping data words on a frame block, so that the former are spaced as evenly as possible.

This is achieved by the features as set forth in the independent claims.

Preferred embodiments are the subject matter of dependent claims.

It is the particular approach of the present invention to compute a conceptional position for each data word, the conceptual positions being equidistant elements of an interval of numbers that represents the entire frame, and to map each data word to a frame word in accordance with its conceptual position.

According to a first aspect of the present invention, a method for convolutionally interleaving a variable-bit-rate data stream is provided. The method comprises the steps of receiving a plurality of data blocks from the variable-bit-rate data stream; mapping each data word of a data block to a distinct data word of a frame block so as to define a frame block for each data block, the frame blocks having a predetermined size; and generating a plurality of interleaved data blocks, each interleaved data block consisting of data words of a corresponding interleaved frame block, the interleaved frame blocks being defined by applying convolutional interleaving to the frame blocks defined in the mapping step, characterized in that the mapping step is spreading the data words of a data block evenly over the data words of a corresponding frame block by computing for each data word of the data block a conceptual position, the conceptual positions of all data words of the data block being equidistant elements of a predetermined interval of numbers, each data word of the frame buffer being associated with a distinct element of said predetermined interval of numbers; and by mapping each data word of the data block to a data word of the frame block in accordance with the conceptual position of the data word and the association of data words of the frame buffer to elements of the predetermined interval of numbers.

According to a further aspect of the present invention, an apparatus for convolutionally interleaving a variable-bit-rate data stream is provided. The encoding apparatus comprises a receiving means for receiving a plurality of data blocks from the variable-bit-rate data stream; a mapping unit for mapping each data word of a data block to a distinct data word of a frame block so as to define a frame block for each data block, the frame blocks having a predetermined size; and an interleaver for generating a plurality of interleaved data blocks, each interleaved data block consisting of data words of a corresponding interleaved frame block, the interleaved frame blocks being defined by applying convolutional interleaving to the frame blocks defined by the mapping unit, characterized in that the mapping unit is adapted for spreading the data words of a data block evenly over the data words of a corresponding frame block by further comprising a first computing unit for computing for each data word of the data block a conceptual position, the conceptual positions of all data words of the data block being equidistant elements of a predetermined interval of numbers, each data word of the frame buffer being associated with a distinct element of said predetermined interval of numbers; and wherein the mapping unit is mapping each data word of the data block to a data word of the frame block in accordance with the conceptual position of the data word and the association of data words of the frame buffer to elements of the predetermined interval of numbers.

According to a further aspect of the present invention, a method for recovering uninterleaved data blocks from a plurality of interleaved data blocks, the interleaved data blocks being generated from uninterleaved data blocks by applying the inventive interleaving method, is provided. The recovering method comprises the steps of receiving the plurality of interleaved data blocks; receiving the number of data words within each of the uninterleaved data blocks; mapping each data word of an interleaved data block to a distinct data word of a frame block so as to define a frame block for each interleaved data block, the frame blocks having the predetermined size; generating a plurality of uninterleaved data blocks, each uninterleaved data block consisting of data words of a corresponding deinterleaved frame block, the deinterleaved frame blocks being defined by applying convolutional deinterleaving to the frame blocks defined in the mapping step, wherein the mapping of each data word of an interleaved data block to a distinct data word of a frame block is performed in accordance with a distribution of data words of data blocks to data words of frame blocks generated by applying the interleaving method to data blocks having the received numbers of data words.

According to a further aspect of the present invention, an apparatus for recovering uninterleaved data blocks from a plurality of interleaved data blocks, the interleaved data blocks being generated from uninterleaved data blocks by means of the inventive interleaving apparatus, is provided. The recovering apparatus comprises a receiving means for receiving the plurality of interleaved data blocks and the number of data words within each of the uninterleaved data blocks; a mapping unit for mapping each data word of an interleaved data block to a distinct data word of a frame block so as to define a frame block for each interleaved data block, the frame blocks having the predetermined size; a deinterleaver for generating a plurality of uninterleaved data blocks, each uninterleaved data block consisting of data words of a corresponding deinterleaved frame block, the deinterleaved frame blocks being defined by applying convolutional deinterleaving to the frame blocks defined in the mapping step, wherein the mapping unit is adapted for mapping each data word of an interleaved data block to a distinct data word of a frame block in accordance with a distribution of data words of data blocks to data words of frame blocks generated by applying the interleaving method employed by the interleaving apparatus to data blocks having the received numbers of data words.

Preferably, the predetermined interval of numbers consists of non-negative integers smaller than or equal to the number of data words within the frame block minus 1, so that each data word of the data block can be mapped to the data word of the frame block indicated by the conceptual position of the data word.

Alternatively, the predetermined interval of numbers consists of non-negative reals smaller than or equal to the number of data words within the frame block minus 1. In this case, a mapping index for each data word of the data block is preferably computed by applying a rounding operator to the conceptual position of the data word, the mapping index being an integer indicating a data word of a frame block. Each data word of the data block may then be mapped to the data word of the frame block indicated by the mapping index of the data word. In this manner, the data words can be spread over the frame words as evenly as possible.

Preferably, the mapping index is a non-negative integer smaller than the number of words within the frame block. In this case, the mapping index can be directly used for addressing data words of the frame block.

Preferably, a first predetermined number is assigned to the conceptional position if the data word is the first data word of the block of data words, the first predetermined number being an element of the predetermined interval of numbers, a second predetermined number is assigned to the conceptional position if the data word is the last data word of the block of data words, the second predetermined number being an element of the predetermined interval of numbers, and conceptual positions larger than the first predetermined number and smaller than the second predetermined number are assigned to data words other than the first and the last data word of the data block. In this manner, the first data word of the data block can be mapped to the first data word of the frame block and the last data word of the data block can be mapped to the last data word of the frame block, if the first and the second predetermined numbers are set to zero and N-1, respectively. In this case, time diversity can be maximized. However, more general setting are possible, for instance in order to achieve integer increments.

Preferably, computing the conceptual position of a current data word comprises adding an increment value to the conceptual position of a data word preceding the current data word. This allows for a simple determination of the conceptual position of each data word in a sequential fashion. Alternatively, computing the conceptual position of a current data word comprises multiplying an index indicating a position of the current data word within the data block with an increment value. In the latter case, computing the conceptual position of a current data word could further comprise adding the first predetermined number to a result of the multiplying step. In this manner, the conceptual positions can computed independently of each other.

Preferably, the increment value is the ratio of the difference of the second and the first predetermined number and the number of data words within the data block minus 1. This ensures that the conceptual positions are spread over the entire interval defined by the first and the second predetermined number. Alternatively, the increment value is the largest integer smaller than the ratio of the difference of the second and the first predetermined number and the number of data words within the data block minus 1. In this case, the increment value is an integer, thus reducing computational overhead.

Preferably, the conceptual position of a data word is expressed as a fraction with denominator equal to the number of data words within the data block minus 1. Further, computing the conceptual position of a current data word preferably comprises adding the difference of the second and the first predetermined number to the numerator of the conceptual position of a data word preceding the current data word. This is an alternative way of sequentially computing the conceptual positions, allowing for straightforward hardware implementation.

Preferably, the first data word of a data block is mapped to the first data word of the corresponding frame block. Further, the last data word of a data block is preferably mapped to the last data word of a corresponding frame block. In this manner, the data words are spread over the entire frame buffer, thus maximizing temporal diversity.

Preferably, the first predetermined number is an integer. Further, the second predetermined number is preferably an integer. In this case the computational effort can be reduced due to integer arithmetic.

Preferably, the second predetermined number is greater than or equal to the first predetermined number plus the number of data words within the data block minus 1. This guarantees that all data words can be mapped to distinct frame words.

Preferably, the rounding operator yields the largest integer smaller than or equal to the conceptual position. Alternatively, the rounding operator yields the smallest integer greater than or equal to the conceptual position. These two options correspond to conventional rounding down and rounding up, respectively, which can be implemented most easily.

More preferably, the rounding operator yields the largest integer smaller than or equal to the conceptual position plus 0.5. Alternatively, the rounding operator yields the smallest integer greater than or equal to the conceptual position minus 0.5. These two options correspond to conventional rounding to the next integer, either rounding down or rounding up in case of the fractional part being equal to one half. This rounding schemes can also be easily implemented and lead to a more even distribution of data words.

Even more preferably, however, the rounding operator yields the largest integer smaller than or equal to the conceptual position plus 0.5 if the conceptual position is smaller than half the number of data words within the frame block and yields the smallest integer greater than or equal to the conceptual position minus 0.5 if the conceptual position is greater than half the number of data words within the frame block. Alternatively, the rounding operator yields the largest integer smaller than or equal to the conceptual position plus 0.5 if the conceptual position is greater than half the number of data words within the frame block and yields the smallest integer greater than or equal to the conceptual position minus 0.5 if the conceptual position is smaller than half the number of data words within the frame block. In other words, the rounding operator may either round up or down to the next integer if the fractional part of the conceptual position is one half, depending on whether the conceptual position is greater or smaller than half the number of data words within the frame block. Each of these two options yields a symmetric - and hence more even distribution of mapping indices.

In conjunction with the above symmetric rounding scheme, the rounding operator may either yield the largest integer smaller than or equal to the conceptual position plus 0.5 if the conceptual position is equal to half the number of data words within the frame block or the smallest integer greater than or equal to the conceptual position minus 0.5 if the conceptual position is equal to half the number of data words within the frame block. In other words, the rounding operator may either round up or down to the next integer if the fractional part of the conceptual position is one half and if the conceptual position is equal to half the number of data words within the frame block.

The present invention is preferably carried out by employing integer arithmetic only, which allows for straightforward hardware implementation. The first computing unit of the corresponding apparatus preferably comprises a modulo accumulator, which is receiving the number of data words within the frame block minus 1 as an increment value and the number of data words within the data block minus 1 as a modulo value. The modulo accumulator is further adapted to add the increment value to a first hold value held by the modulo accumulator, to divide the result by the modulo value, and to output both the integer part and the remainder of the division as an overflow value and the new first hold value, respectively. The first computing unit preferably comprises also an overflow accumulator for adding the overflow value output by the modulo accumulator to a second hold value held by the overflow accumulator and for outputting the second hold value, whereas the second computing unit receives the first hold value and the second hold value, computes the mapping index of the data word of the data block in accordance with the hold values received, and outputs an index indicating the mapping index computed. In this manner, the mapping index for each data word of the data block is computed in a sequential fashion.

The above and other objects and features of the present invention will become more apparent from the following description and preferred embodiments given in conjunction with the accompanying drawings, in which:
- Fig. 1A: is a schematic drawing illustrating multiplexing of service data onto an OFDM frame using time slicing (TS);
- Fig. 1 B: is a schematic drawing illustrating multiplexing of service data onto an OFDM frame using time-frequency slicing (TFS);
- Fig. 2A: is a block diagram illustrating a convolutional interleaver with K = 4 and D = 5;
- Fig. 2B: is a block diagram illustrating a convolutional deinterleaver with K = 4 and D = 5;
- Fig. 3A: is a schematic drawing illustrating the input data of an exemplary convolutional interleaving and deinterleaving process;
- Fig. 3B: is a schematic drawing illustrating the interleaved data of an exemplary convolutional interleaving and deinterleaving process;
- Fig. 3C: is a schematic drawing illustrating the output data of an exemplary convolutional interleaving and deinterleaving process;
- Fig. 4A: is a schematic drawing illustrating the input data of an exemplary conventional convolutional interleaving process of a variable-bit-rate data stream;
- Fig. 4B: is a schematic drawing illustrating the input data and the appended dummy blocks of an exemplary conventional convolutional interleaving process of a variable-bit-rate data stream;
- Fig. 4C: is a schematic drawing illustrating the interleaved data of an exemplary conventional convolutional interleaving process of a variable-bit-rate data stream;
- Fig. 4D: is a schematic drawing illustrating the resulting data of an exemplary conventional convolutional interleaving process of a variable-bit-rate data stream;
- Fig. 5A: is a schematic drawing illustrating a conventional method of inserting dummy words;
- Fig. 5B: is a schematic drawing illustrating a method of inserting dummy words according to an embodiment of the present invention;
- Fig. 6A: is a schematic drawing illustrating the input data of an exemplary convolutional interleaving process of a variable-bit-rate data stream according to an embodiment of the present invention;
- Fig. 6B: is a schematic drawing illustrating the input data mapped to fixed-size frame blocks of an exemplary convolutional interleaving process of a variable-bit-rate data stream according to an embodiment of the present invention;
- Fig. 6C: is a schematic drawing illustrating the interleaved data of an exemplary convolutional interleaving process of a variable-bit-rate data stream according to an embodiment of the present invention;
- Fig. 6D: is a schematic drawing illustrating the resulting data of an exemplary convolutional interleaving process of a variable-bit-rate data stream according to an embodiment of the present invention;
- Fig. 7A: is a schematic drawing illustrating the conceptual spacing of the data words according to the present invention;

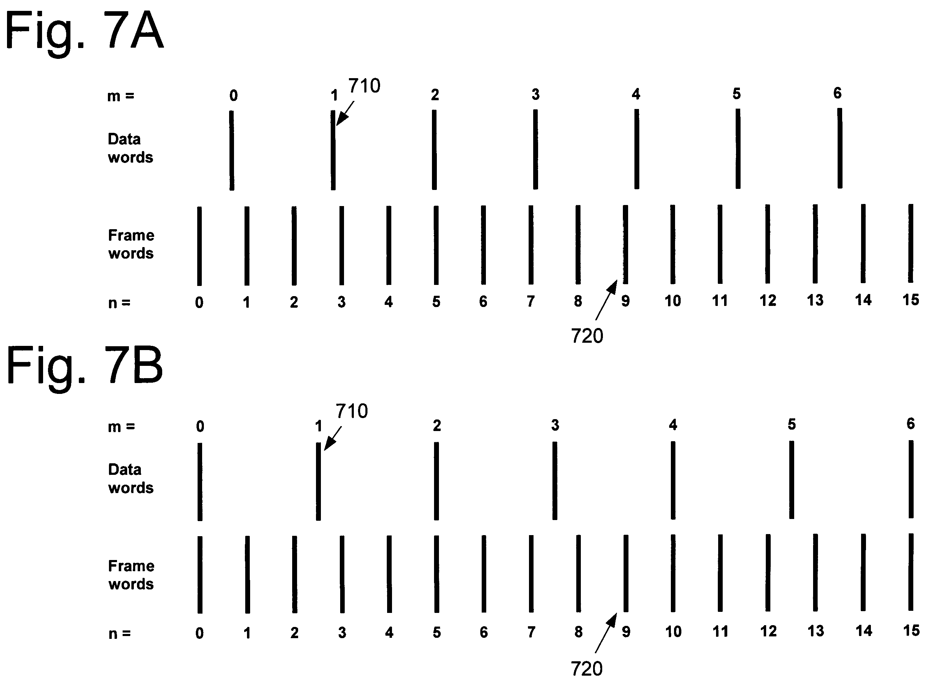

- Fig. 7A: is a schematic drawing illustrating the conceptual spacing of the data words according to an embodiment of the present invention;

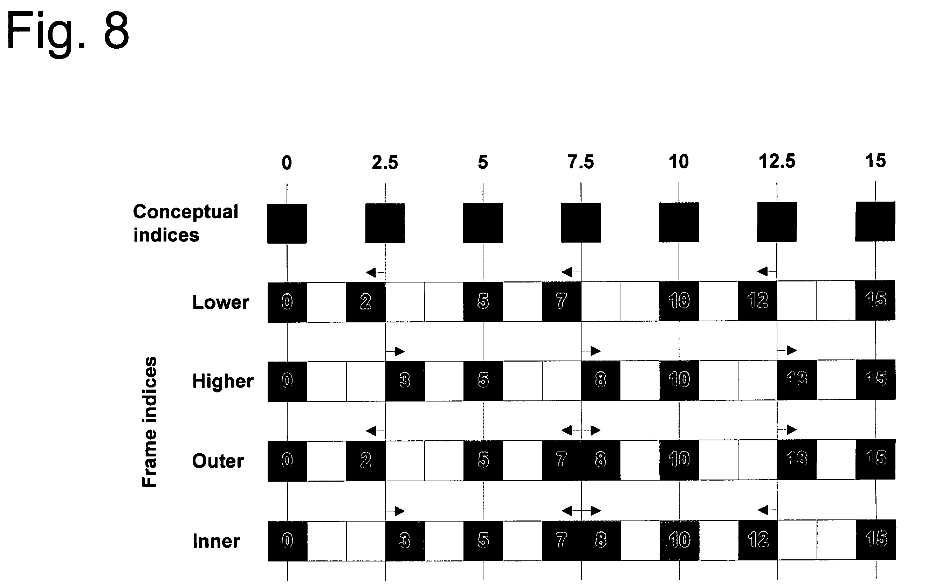

- Fig. 8: is a schematic drawing illustrating the method for computing frame indices by rounding of the conceptual positions according to embodiments of the present invention;

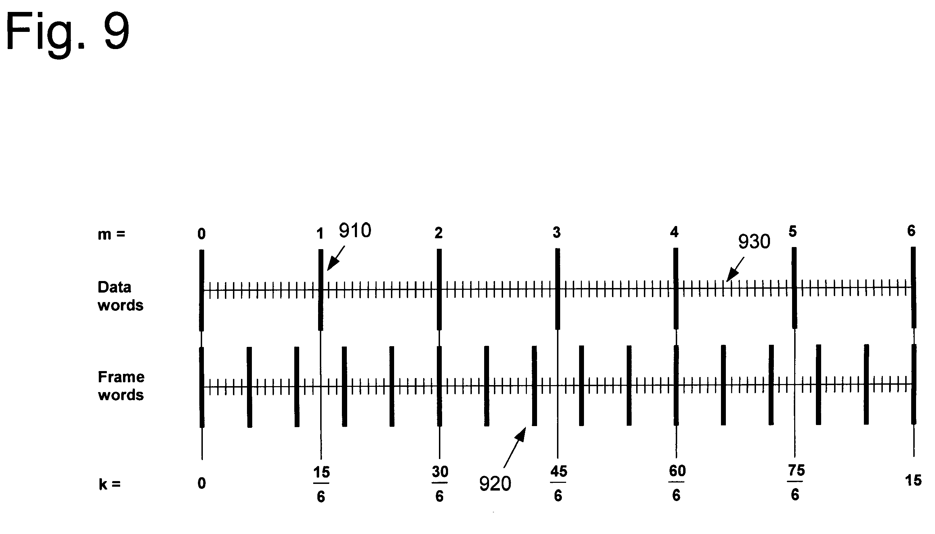

- Fig. 9: is a schematic drawing illustrating the common grid of the data and frame words according to the present invention;

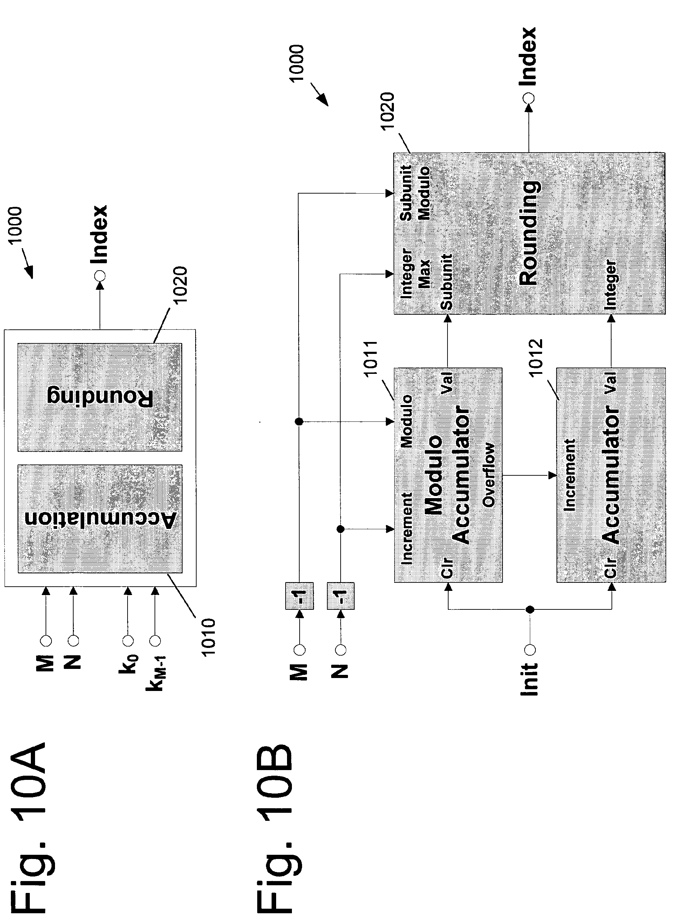

- Fig. 10A: is a block diagram of a hardware implementation of the mapping unit according to an embodiment of the present invention;
- Fig. 10B: is a block diagram of a hardware implementation of the mapping unit according to another embodiment of the present invention;

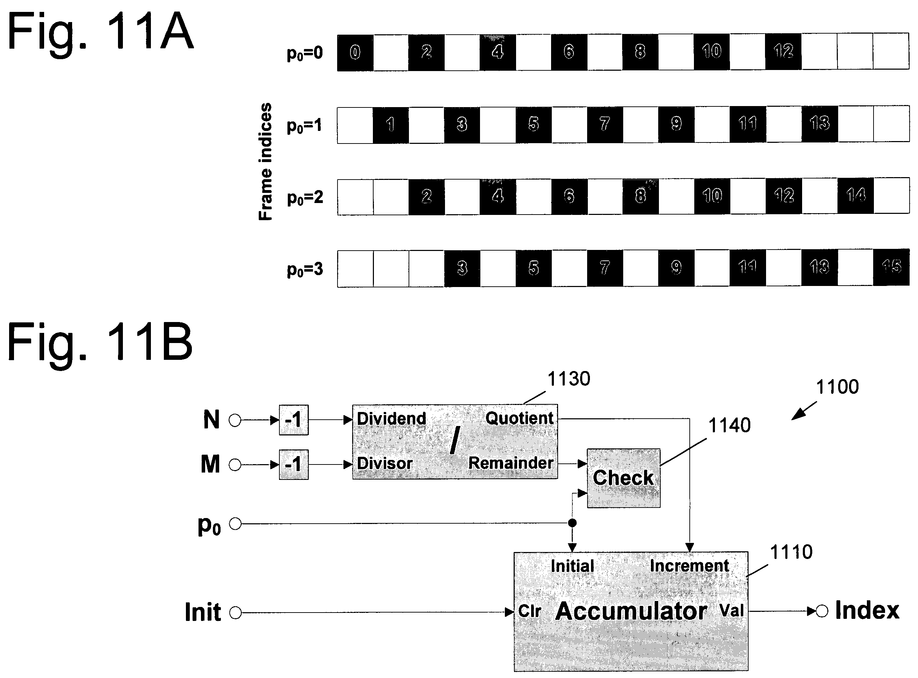

- Fig. 11A: is a schematic drawing illustrating the mapping of data words to frame words according to another embodiment of the present invention;
- Fig. 11 B: is a block diagram of a hardware implementation of the mapping unit according to the embodiment of the present invention shown in Fig 11A;

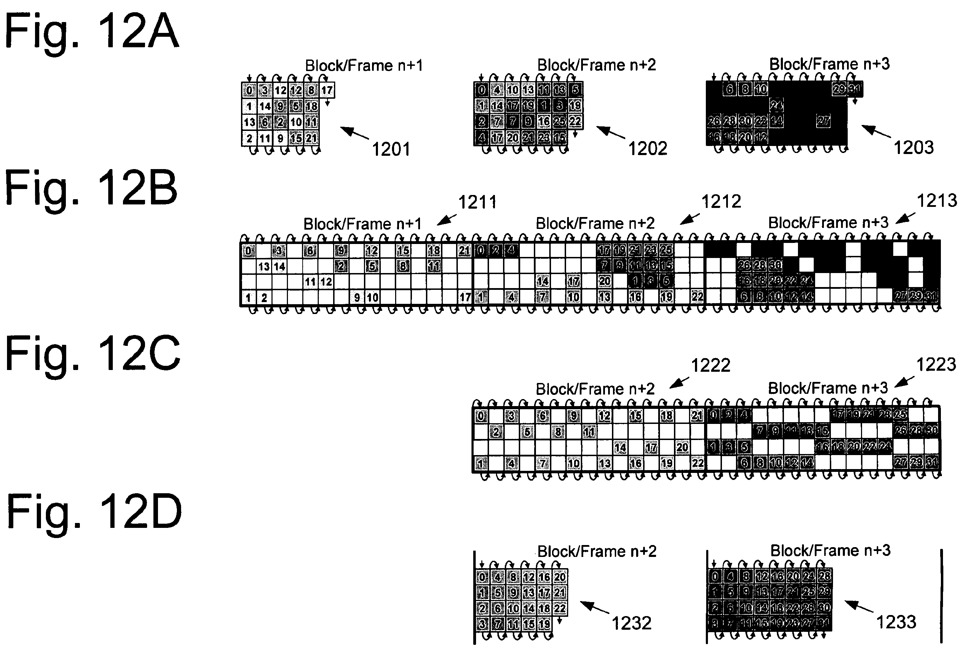

- Fig. 12A: is a schematic drawing illustrating the interleaved input data of an exemplary convolutional de-interleaving process of a variable-bit-rate data stream according to an embodiment of the present invention;
- Fig. 12B: is a schematic drawing illustrating the interleaved input data mapped to fixed-size frame blocks of an exemplary convolutional de-interleaving process of a variable-bit-rate data stream according to an embodiment of the present invention;
- Fig. 12C: is a schematic drawing illustrating the deinterleaved frame blocks of an exemplary convolutional deinterleaving process of a variable-bit-rate data stream according to an embodiment of the present invention; and
- Fig. 12D: is a schematic drawing illustrating the resulting data of an exemplary convolutional deinterleaving process of a variable-bit-rate data stream according to an embodiment of the present invention.

### DETAILED DESCRIPTION

In order to overcome the problems of the conventional approach, data words are are evenly spaced over the entire frame block (500) and dummy words (520) are inserted in between. Figure 5B is a schematic drawing of such an exemplary frame block (500) consisting of 60 frame words on which 24 data words (shaded squares, 510) have been mapped in a distributive manner according to an embodiment of the present invention.

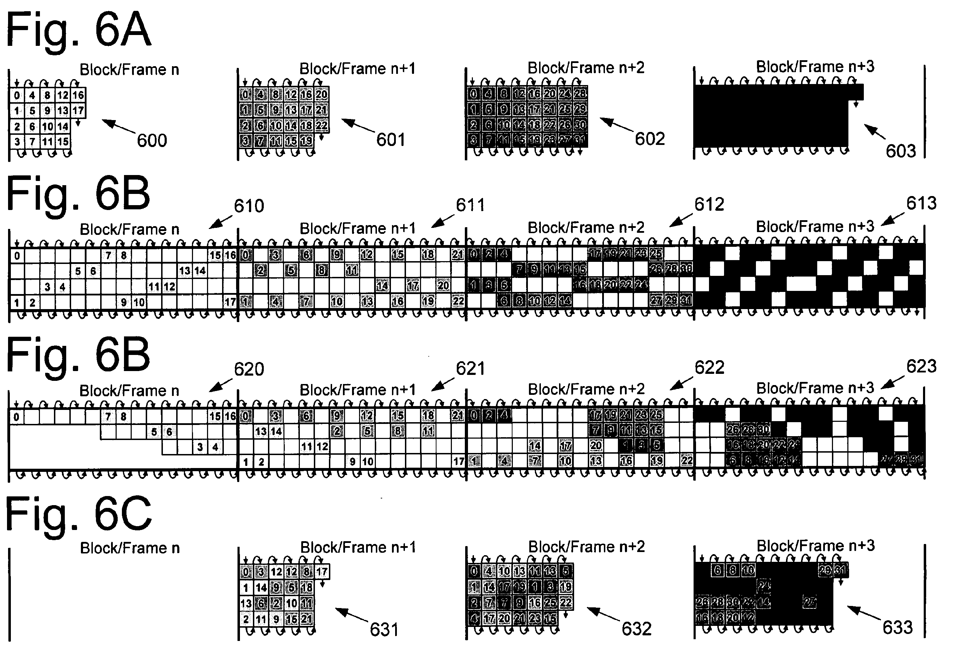

With this approach, the loss of time diversity for variable-bit-rate data streams can be avoided, as illustrated in Fig. 6, which exemplifies the inventive interleaving process a block size of 60 words, corresponding to the example of Figure 4. In Fig. 6A, four variable-size data blocks are shown, consisting of 18, 23, 32, and 41 words respectively. Each of these blocks contains the data generated by the service during the corresponding frame. In Fig. 6B a each of the data words is mapped to a frame word of the corresponding frame block. The resulting frame blocks are then interleaved (Fig. 6C) and the dummy words are removed (Fig. 6D). The insertion and removal of dummy words does not need to be physical, as this would increase the memory and throughput requirements. Instead, appropriate index manipulations may be performed on the data words of the data blocks. Regardless of the actual implementation, the resulting interleaved data blocks will look like in Fig. 6D. As it is apparent from these figures, the loss of time diversity is substantially reduced as compared to the conventional approach illustrated in Fig. 4.

The present invention provides a solution to the problem of where to insert the dummy words, or how to map the data words on the frame block, so that the former are spaced as evenly as possible over the frame block.

The main idea of the present invention is illustrated in Fig. 7A. As a first step, a conceptual position 710 is assigned to each data word (upper row in Fig 7A). The conceptual position may be represented by a real number. In general, the conceptual position does not coincide with the position of one of the frame words 720, which are located at integer "positions" within the frame buffer (lower row in Fig. 7A). In order to arrange the data words as evenly as possible on the frame buffer, the conceptual positions are equidistant, i.e., the difference between the conceptual position of two consecutive data words is constant for all data words of the data block.

In the second step, each data word is mapped to the frame word that is located closest to its conceptual position. The actual mapping position of each data word may for instance be derived from the conceptual position by applying a rounding operator. This will be explained in greater detail below in conjunction with Fig. 8.

Figure 7B illustrates a specific embodiment of the present invention, wherein the first data word (m=0) is mapped to the first frame word (n=0) and the last data word (m=6) is mapped to the last frame word (n=15). According to this embodiment, the data words are spread evenly over the entire frame block, thus maximizing time diversity.

The merits of the inventive solution are twofold. First, it guarantees that the data words are distributed as evenly as possible over the whole frame, thus maximizing the time diversity. Second, the resulting mapping depends only on the number of data and frame words. As the number of frame words is usually fixed and therefore known, only the number of data words needs to be signaled to the receiver, not the actual mapping pattern, in order to allow the receiver to de-interleave the received data blocks.

In the following, a more specific description of the mapping process is provided. We need to map *M* data words onto a frame block of *N* words, where *M* ≤ *N.* We define *m* as the data word index from 0 to *M*-1 and *n* as the frame word index from 0 to *N-*1.

The first step is to map data word 0 to a conceptual position k₀ and data word M-1 to a conceptual index k_{M-1}, where 0 ≤ k₀ < k_{M-1} ≤ N-1. These conceptual positions may also be real valued, not necessarily integers.

The remaining M-2 data words are conceptually spaced evenly between data words 0 and M-1, as shown in Figure 7A for M=7 and N=16. This case will be considered as an example from now on. Obviously, these numbers are merely exemplary and do not imply any restriction regarding the applicability of the present invention. In fact, the present invention can be carried out for any combination of number of data words *M* and number of frame words *N* as long as *M* ≤ *N*.

The resulting conceptual positions are an arithmetical progression of *M* elements from k₀ to k_{M-1}. The difference of two successive indices will thus be *D*=(k_{M-1}-k₀)/(M-1). The initial k₀ and k_{M-1} must be chosen so that this difference is at least 1 in order to ensure that all data words are mapped to distinct frame words. This condition can be also expressed as: k_{M-1}- k₀ ≥ M-1. The general expression for the conceptual indices will be: kₘ = k₀+*m D* = k₀+m(k_{M-1}- k₀)/(M-1), where *m* is the data-word index ranging from 0 to M-1.

The actual integer frame indices (mapping positions) of the data words are obtained by rounding the real conceptual indices computed at the previous point: pₘ *= round* (kₘ). The result will be *M* distinct indices between 0 and *N*-1, in ascending order.

According to a preferred embodiment of the present invention, the first data word is mapped to the first frame word (k₀ = 0) and/or the last data word is mapped to the last frame word (k_{M-1} = N-1). In this case the first step described above reduces to mapping data word 0 to frame word 0 and data word *M*-1 to frame word *N*-1. The remaining *M*-2 data words are then conceptually spaced uniformly between 0 and *N*-1, as shown in Figure 7B for *M*=7 and *N*=16.

The conceptual spacing between the data words, normalized to the spacing of the frame words, is thus *D_{M}* = (*N*-1)/(*M*-1). D_{M} is greater than 1, except when *M*=*N.* The resulting conceptual positions of the data words can be expressed as: *k*ₘ = *m*×*D*_{M}, where *m*∈[0; *M*-1].

The actual indices (mapping positions) of the data words on the frame are determined by rounding the conceptual positions: *pₘ = round*(*m*(*N*-1)/(*M*-1)), where *m*∈[0; *M*-1]. It can be easily verified that *pₘ* = 0 for *m* = 0 and that *pₘ* = *N*-1 for *m* = *M*-1.

The *round* operator rounds a real value to the nearest integer. However, when its argument is of the form *X*.5, where *X* is an integer, *round* has an undefined behavior. A total of four possibilities exist, as shown in Fig. 8:
1. "Lower": round towards the next lower integer
2. "Higher": Round towards the next higher integer
3. "Outer": round towards the nearest end of the [0; *N*-1] interval
4. "Inner": round towards the middle of the [0; *N*-1] interval

The conceptual positions in this example are: 0, 2.5, 5.0, 7.5, 10.0, 12.5, 15.0. The example has been chosen so as to contain conceptual positions of the form X.5. In Fig. 8, the arrows show the rounding direction. It can be seen that for "lower" and "higher" rounding, the resulting pattern is not symmetrical and the data words with conceptual positions of form X.5 will have a consistent offset of -0.5 or +0.5. Therefore, "outer" and "inner" are considered as the preferred embodiments of the rounding operator.

For "outer" and "inner" rounding, hereafter referred to as symmetrical rounding, the decision to round to the next lower or higher integer depends on whether the conceptual position is lower or higher than the middle of the interval, (N-1)/2. An undefined case occurs when N is even and M is odd. This occurs with a probability of 0.5 in the case of mapping for convolutional interleaving, since the interleaver block size N is always even. In this case, the conceptual position of the middle data word coincides with the middle of the interval and we can chose to round either to the next lower or to the next higher integer.

The above generic algorithm can be implemented by repeating a sequence of two operations: an accumulation (summation) of an increment value and a rounding. Therefore, both hardware and software implementations can be envisaged.

Figure 10A shows a block diagram of a mapping unit for mapping data words to frame words according to a preferred embodiment of the present invention. The mapping unit 1000 comprises an accumulation unit 1010 and a rounding unit 1020. For each new frame, the accumulation unit 1010 is initialized with k₀, which is the conceptual index of the first data word. The conceptual indices of the subsequent data words are computed sequentially by accumulating the increment value D = (k_{M-1}-k₀)/(M-1). After M-1 steps, the accumulation unit 1010 will contain the conceptual index of the last data word, i.e. k_{M-1}. The output of the accumulation unit 1010 is fed to the rounding unit for rounding the conceptual index to the mapping index as explained above in conjunction with Fig. 8.

According to a preferred embodiment of the present invention, the mapping indices of the data words can be computed by using integer arithmetic only. This embodiment is particularly suitable for hardware implementation.

The first step is to understand that all data words (910) and frame words (920) are located on a common fine grid (930), as indicated in Figure 9. In the general case, the number of fine grid divisions is (*M*-1)(*N*-1) over the whole interval. Therefore, the spacing between two data words is *N*-1, and the spacing between two frame words is *M*-1.

From Fig. 9 it is also apparent that the conceptual positions of the data words can be expressed as a fraction with denominator *M*-1. For each data word, the numerator can be computed by repeatedly accumulating *M*-1, starting from 0 for the first data word. In other words, the numerator of the conceptual position of a data word can be computed from the conceptual position of the previous data word by adding *M*-1 to the numerator. The actual position (mapping index) of a data word can then be derived from its conceptual position by applying the appropriate rounding operation. Hence, the mapping indices for all data words can be easily computed in an iterative or sequential manner.

Fig. 10B is a block diagram of a hardware-implemented mapping unit (1000) for determining a mapping index for each data word according to an embodiment of the present invention.

The mapping unit comprises a modulo accumulator (1011), an overflow accumulator (1012) for the integer overflow, and a rounding unit (1020). For each new frame, both accumulators (1011, 1012) are initialized with zero via a reset signal (Clr). For each data word, *N*-1 is added to the modulo accumulator (1011), the resulting integer overflow being accumulated in the overflow accumulator (1012). Thus, the modulo accumulator (1011) will contain the subunit part of the conceptual position of the data words, and the overflow accumulator (1012) the integer part thereof. Both subunit and integer parts are fed to the rounding block (1020), which computes the final mapping index by conditionally incrementing the integer part. Thus, the circuit computes the mapping indices of the data words sequentially.

Figure 11 illustrates another preferred embodiment of the present invention. In accordance with this embodiment, and in contrast to the embodiments described above, the mapping indices are now guaranteed to be equidistant. To this end, the first data word is mapped on frame index *p*₀, where *p*₀ is any non-negative integer for which floor((*N*-1-p₀)/(*M*-1)) = floor((*N*-1)/(*M*-1)), preferably *p*₀ = 0. Here, the floor () operator returns the nearest smaller integer. This condition is fulfilled if *p*₀ does not exceed the remainder of the division of (*N*-1) by (*M*-1). For the considered example, i.e. *M*=7 and *N*=16, the resulting remainder of 15/6 is 3, therefore *p*₀ can be one of: 0, 1, 2, 3. In contrast to the embodiments described above, where we set conceptual indices *k*₀ and *k*_{*M*-1} for the first and the last data word, respectively, we set now the integer frame index for the first data word directly. No frame index is set for the last data word at this point.

In a second step, an integer increment *D* is computed according to the formula: *D* = floor((*N*-1)/(*M*-1)). In our example, the resulting value for *D* is 2. The increment *D* can be also expressed as the quotient of the division of (*N*-1) by (*M*-1). In contrast to the embodiments described above, where the resulting increment is real, the increment is now constrained to an integer.

In a third step, the integer frame indices of the data words are computed according to the formula *pₘ*= *p*₀+*m D,* where *m* is the data word index from 0 to *M*-1. The conditions of point 1 and 2 ensure that the resulting frame index of the last data word does not exceed *N*-1.

Fig. 11A shows the resulting mapping for all four values of p0: 0, 1, 2, and 3.

This embodiment has the advantage that the frame indices of the data words are computed using an integer accumulation and no extra rounding is required. However, the computation of the increment requires a division.

The block diagram of a possible implementation of a mapping unit according to this embodiment is shown in Figure 11B. The mapping unit comprises a divider 1130 for computing the increment D and an accumulator 1110 for computing the mapping indices. For each new frame, the integer accumulator is initialized with *p*₀. For each data word, the computed increment D is added. The value of the accumulator can be directly used as the frame index.

The increment *D* is calculated as the quotient of the division of (*N*-1) by (*M*-1). The remainder of this division can be used for checking if *p*₀ has a legal value, e.g. via the check unit 1140. It is worth mentioning that only one division operation is required for each frame, which allows a slower sequential division algorithm to be used.

Fig. 12 illustrates an exemplary deinterleaving process in accordance with embodiments of the present invention. In order to deinterleave interleaved data blocks received at a receiver, the receiver basically has to perform the inverse operation, i.e., to map each data word of an interleaved data block to a data words of an "interleaved" frame block, to deinterleave the interleaved frame blocks, and to remove the dummy words from the deinterleave frame blocks.

Fig. 12A shows the interleaved data blocks of Fig. 6D, which are subjected to the deinterleaving process. Fig. 12B is the result of mapping the data words of each data block to a corresponding frame block. The result of applying convolutional deinterleaving is illustrated in Fig. 12C. The recovered data blocks are shown in Fig. 12D.

In order to know how to map the data words to a frame, the receiver needs to know the sizes of the two original uninterleaved data blocks that contribute to an interleaved frame block. For example, in order to insert the dummy words for block/frame n+1 in Fig. 12A, the knowledge of the sizes of the uninterleaved blocks n and n+1 in Fig. 6A, is required. The transmitter will need to signal these sizes to the receiver.

Although the present invention has been described in the context of orthogonal frequency-division multiplexing and DVB-T2, it may also be applied to other modulation techniques and other communication systems. In particular, the present invention can be applied to any frame-based digital communication system in order to increase time diversity for coding of variable-rate bitstreams.

Summarizing, the present invention discloses a method and a corresponding apparatus for interleaving variable-bit-rate data streams by mapping variable-size data blocks, each obtained within one frame, to fixed-size frame blocks that consists of a larger or equal number of words. The resulting frame blocks may then be subjected to convolutional interleaving. The algorithm ensures that the data words are distributed as evenly as possible over the entire frame in order to maximize time diversity.

## Claims

1. A method for convolutionally interleaving a variable-bit-rate data stream, the method comprising the steps of
receiving a plurality of data blocks (600-603) from the variable-bit-rate data stream;
mapping each word of a data block (600-603) to a distinct word of a frame block (610-613) so as to define a frame block for each data block, the frame blocks having a predetermined size (N); and
generating a plurality of interleaved data blocks (631-633), each interleaved data block (631-633) consisting of words of a corresponding interleaved frame block (621-623), the interleaved frame blocks being defined by applying convolutional interleaving to the frame blocks (610-613) defined in the mapping step,
**characterized in that** the mapping step is spreading the words of a data block evenly over the words of a corresponding frame block by
computing for each word of the data block a conceptual position (k), the conceptual positions of all words of the data block being equidistant elements of a predetermined interval of numbers, each word of the frame buffer being associated with a distinct element of said predetermined interval of numbers; and by
mapping each word of the data block to a word of the frame block in accordance with the conceptual position (k) of the word and the association of words of the frame buffer to elements of the predetermined interval of numbers.

2. A method according to claim 1, wherein the predetermined interval of numbers consists of non-negative integers smaller than or equal to the number of words within the frame block (N) minus 1, and wherein each word of the data block is mapped to the word of the frame block indicated by the conceptual position (k) of the word.

3. A method according to claim 1, wherein the predetermined interval of numbers consists of non-negative reals smaller than or equal to the number of words within the frame block (N) minus 1, and wherein the mapping step further comprises the step of
computing for each word of the data block a mapping index (p) by applying a rounding operator to the conceptual position (k) of the word, the mapping index (p) being an integer indicating a word of a frame block; and
wherein each word of the data block is mapped to the word of the frame block indicated by the mapping index (p) of the word.

4. A method according to claim 3, wherein the mapping index (p) is a non-negative integer smaller than the number of words within the frame block.

5. A method according to any of claims 1 to 4, wherein the step of computing the conceptual position (k) of a word comprises the steps of
assigning a first predetermined number (k₀) to the conceptional position if the word is the first word of the block of words, the first predetermined number (k₀) being an element of the predetermined interval of numbers;
assigning a second predetermined number (k_{M-1}) to the conceptional position if the word is the last word of the block of words, the second predetermined number (k_{M-1}) being an element of the predetermined interval of numbers; and
assigning conceptual positions larger than the first predetermined number (k₀) and smaller than the second predetermined number (k_{M-1}) to words other than the first and the last word of the data block.

6. A method according to claim 5, wherein the step of computing the conceptual position (k) of a current word comprises adding an increment value (D) to the conceptual position (k) of a word preceding the current word.

7. A method according to claim 5, wherein the step of computing the conceptual position (k) of a current word comprises multiplying an index indicating a position of the current word within the data block with an increment value (D).

8. A method according to claim 7, wherein the step of computing the conceptual position (k) of a current word further comprises adding the first predetermined number (k₀) to a result of the multiplying step.

9. A method according to any of claims 6 to 8, wherein the increment value (D) is the ratio of the difference of the second and the first predetermined number (k_{M-1}, k₀) and the number of words within the data block (M) minus 1.

10. A method according to any of claims 6 to 8, wherein the increment value (D) is the largest integer smaller than the ratio of the difference of the second and the first predetermined number (k_{M-1}, k₀) and the number of words within the data block (M) minus 1.

11. A method according to claim 5, wherein the conceptual position (k) of a word is expressed as a fraction with denominator equal to the number of words within the data block (M) minus 1.

12. A method according to claim 11, wherein the step of computing the conceptual position (k) of a current word further comprises adding the difference of the second and the first predetermined number (k_{M-1}, k₀) to the numerator of the conceptual position (k) of a word preceding the current word.

13. A method according to any of claims 1 to 12, wherein the first word of a data block is mapped to the first word of the corresponding frame block.

14. A method according to any of claims 1 to 13, wherein the last word of a data block is mapped to the last word of a corresponding frame block.

15. A method according to any of claims 5 to 14, wherein the first predetermined number (k₀) is an integer.

16. A method according to any of claims 5 to 15, wherein the second predetermined number (k_{M-1}) is an integer.

17. A method according to any of claims 5 to 16, wherein the second predetermined number (k_{M-1}) is greater than or equal to the first predetermined number (k₀) plus the number of words within the data block (M) minus 1.

18. A method according to any of claims 3 to 17, wherein the rounding operator yields the largest integer smaller than or equal to the conceptual position (k).

19. A method according to any of claims 3 to 17, wherein the rounding operator yields the smallest integer greater than or equal to the conceptual position (k).

20. A method according to any of claims 3 to 17, wherein the rounding operator yields the largest integer smaller than or equal to the conceptual position (k) plus 0.5.

21. A method according to any of claims 3 to 17, wherein the rounding operator yields the smallest integer greater than or equal to the conceptual position (k) minus 0.5.

22. A method according to any of claims 3 to 17, wherein the rounding operator yields the largest integer smaller than or equal to the conceptual position (k) plus 0.5 if the conceptual position (k) is smaller than half the number of words within the frame block (N) and yields the smallest integer greater than or equal to the conceptual position (k) minus 0.5 if the conceptual position (k) is greater than half the number of words within the frame block (N).

23. A method according to any of claims 3 to 17, wherein the rounding operator yields the largest integer smaller than or equal to the conceptual position (k) plus 0.5 if the conceptual position (k) is greater than half the number of words within the frame block (N) and yields the smallest integer greater than or equal to the conceptual position (k) minus 0.5 if the conceptual position (k) is smaller than half the number of words within the frame block (N).

24. A method according to claim 22 or 23, wherein the rounding operator yields the largest integer smaller than or equal to the conceptual position (k) plus 0.5 if the conceptual position (k) is equal to half the number of words within the frame block (N).

25. A method according to claim 22 or 23, wherein the rounding operator yields the smallest integer greater than or equal to the conceptual position (k) minus 0.5 if the conceptual position (k) is equal to half the number of words within the frame block (N).

26. A method for recovering uninterleaved data blocks from a plurality of interleaved data blocks, the interleaved data blocks being generated from uninterleaved data blocks by applying an interleaving method according to any of claims 1 to 25, the recovering method comprising the steps of
receiving the plurality of interleaved data blocks (1201-1203);
receiving the number of words within each of the uninterleaved data blocks (1232, 1233);
mapping each word of an interleaved data block (1201-1203) to a distinct word of a frame block (1211-1213) so as to define a frame block (1211-1213) for each interleaved data block (1201-1203), the frame blocks (1211-1213) having the predetermined size;
generating a plurality of uninterleaved data blocks (1232, 1233), each uninterleaved data block (1232, 1233) consisting of words of a corresponding deinterleaved frame block (1222, 1223), the deinterleaved frame blocks (1211-1213) being defined by applying convolutional deinterleaving to the frame blocks (1211-1213) defined in the mapping step,
wherein the mapping of each word of an interleaved data block (1201-1203) to a distinct word of a frame block is performed in accordance with a distribution of words of data blocks to words of frame blocks generated by applying the interleaving method to data blocks having the received numbers of words.

27. A computer program product comprising a computer readable medium having computer readable program code embodied thereon, the program code being adapted to carry out all steps of any of claims 1 to 26.

28. An apparatus for convolutionally interleaving a variable-bit-rate data stream, the apparatus comprising
a receiving means for receiving a plurality of data blocks (600-603) from the variable-bit-rate data stream;
a mapping unit (1000; 1100) for mapping each word of a data block to a distinct word of a frame block so as to define a frame block for each data block, the frame blocks having a predetermined size; and
an interleaver for generating a plurality of interleaved data blocks (631-633), each interleaved data block consisting of words of a corresponding interleaved frame block, the interleaved frame blocks being defined by applying convolutional interleaving to the frame blocks defined by the mapping unit (1000; 1100),
**characterized in that** the mapping unit (1000; 1100) is adapted for spreading the words of a data block evenly over the words of a corresponding frame block by further comprising
a first computing unit (1010; 1110) for computing for each word of the data block a conceptual position (k), the conceptual positions of all words of the data block being equidistant elements of a predetermined interval of numbers, each word of the frame buffer being associated with a distinct element of said predetermined interval of numbers; and wherein
the mapping unit (1000; 1100) is mapping each word of the data block to a word of the frame block in accordance with the conceptual position (k) of the word and the association of words of the frame buffer to elements of the predetermined interval of numbers.

29. An apparatus according to claim 28, wherein the predetermined interval of numbers consists of non-negative integers smaller than or equal to the number of words within the frame block (N) minus 1, and wherein each word of the data block is mapped to the word of the frame block indicated by the conceptual position (k) of the word.

30. An apparatus according to claim 28, wherein the predetermined interval of numbers consists of non-negative reals smaller than or equal to the number of words within the frame block (N) minus 1, and wherein the mapping unit (1000; 1100) further comprises
a second computing unit (1020) for computing for each word of the data block a mapping index (p) by applying a rounding operator to the conceptual position (k) of the word, the mapping index (p) being an integer indicating a word of a frame block; and
wherein each word of the data block is mapped to the word of the frame block indicated by the mapping index (p) of the word.

31. An apparatus according to claim 30, wherein the mapping index (p) is a non-negative integer smaller than the number of words within the frame block.

32. An apparatus according to any of claims 28 to 31, wherein the first computing unit (1010; 1110) is adapted for
assigning a first predetermined number (k₀) to the conceptional position if the word is the first word of the block of words, the first predetermined number (k₀) being an element of the predetermined interval of numbers;
assigning a second predetermined number (k_{M-1}) to the conceptional position if the word is the last word of the block of words, the second predetermined number (k_{M-1}) being an element of the predetermined interval of numbers; and
assigning conceptual positions larger than the first predetermined number (k₀) and smaller than the second predetermined number (k_{M-1}) to words other than the first and the last word of the data block.

33. An apparatus according to claim 32, wherein the first computing unit (1010; 1110) comprises an adder for adding an increment value (D) to the conceptual position (k) of a word preceding the current word.

34. An apparatus according to claim 32, wherein the first computing unit (1010; 1110) comprises an multiplier for multiplying an index indicating a position of the current word within the data block with an increment value (D).

35. An apparatus according to claim 34, wherein the first computing unit (1010; 1110) further comprises an adder for adding the first predetermined number (k₀) to an output of the multiplier.

36. An apparatus according to any of claims 33 to 35, wherein the increment value (D) is the ratio of the difference of the second and the first predetermined number (k_{M-1}, k₀) and the number of words within the data block (M) minus 1.

37. An apparatus according to any of claims 33 to 35, wherein the increment value (D) is the largest integer smaller than the ratio of the difference of the second and the first predetermined number (k_{M-1}, k₀) and the number of words within the data block (M) minus 1.

38. An apparatus according to claim 32, wherein the conceptual position (k) of a word is expressed as a fraction with denominator equal to the number of words within the data block (M) minus 1.

39. An apparatus according to claim 38, wherein the first computing unit (1010; 1110) further comprises an adder for adding the difference of the second and the first predetermined number (k_{M-1}, k₀) to the numerator of the conceptual position (k) of a word preceding the current word.

40. An apparatus according to any of claims 28 to 39, wherein the first word of a data block is mapped to the first word of the corresponding frame block.

41. An apparatus according to any of claims 28 to 40, wherein the last word of a data block is mapped to the last word of a corresponding frame block.

42. An apparatus according to any of claims 32 to 41, wherein the first predetermined number (k₀) is an integer.

43. An apparatus according to any of claims 32 to 42, wherein the second predetermined number (k_{M-1}) is an integer.

44. An apparatus according to any of claims 32 to 43, wherein the second predetermined number (k_{M-1}) is greater than or equal to the first predetermined number (k₀) plus the number of words within the data block (M) minus 1.

45. An apparatus according to any of claims 30 to 44, wherein the rounding operator yields the largest integer smaller than or equal to the conceptual position (k).

46. An apparatus according to any of claims 30 to 44, wherein the rounding operator yields the smallest integer greater than or equal to the conceptual position (k).

47. An apparatus according to any of claims 30 to 44, wherein the rounding operator yields the largest integer smaller than or equal to the conceptual position (k) plus 0.5.

48. An apparatus according to any of claims 30 to 44, wherein the rounding operator yields the smallest integer greater than or equal to the conceptual position (k) minus 0.5.

49. An apparatus according to any of claims 30 to 44, wherein the rounding operator yields the largest integer smaller than or equal to the conceptual position (k) plus 0.5 if the conceptual position (k) is smaller than half the number of words within the frame block (N) and yields the smallest integer greater than or equal to the conceptual position (k) minus 0.5 if the conceptual position (k) is greater than half the number of words within the frame block (N).

50. An apparatus according to any of claims 30 to 44, wherein the rounding operator yields the largest integer smaller than or equal to the conceptual position (k) plus 0.5 if the conceptual position (k) is greater than half the number of words within the frame block (N) and yields the smallest integer greater than or equal to the conceptual position (k) minus 0.5 if the conceptual position (k) is smaller than half the number of words within the frame block (N).

51. An apparatus according to claim 49 or 50, wherein the rounding operator yields the largest integer smaller than or equal to the conceptual position (k) plus 0.5 if the conceptual position (k) is equal to half the number of words within the frame block (N).

52. An apparatus according to claim 49 or 50, wherein the rounding operator yields the smallest integer greater than or equal to the conceptual position (k) minus 0.5 if the conceptual position (k) is equal to half the number of words within the frame block (N).

53. An apparatus according to any of claims 30 to 52, wherein the first computing unit (1010; 1110) further comprises
a modulo accumulator, which is receiving the number of words within the frame block (N) minus 1 as an increment value (D) and the number of words within the data block (M) minus 1 as a modulo value, said modulo accumulator being adapted to add the increment value (D) to a first hold value held by the modulo accumulator, to divide the result by the modulo value, and to output both the integer part and the remainder of the division as an overflow value and the new first hold value, respectively; and
an overflow accumulator for adding the overflow value output by the modulo accumulator to a second hold value held by the overflow accumulator and for outputting the second hold value, and
wherein the second computing unit (1020) receives the first hold value and the second hold value, computes the mapping index (p) of the word of the data block (600-603) in accordance with the hold values received, and outputs an index indicating the mapping index (p) computed.

54. An apparatus for recovering uninterleaved data blocks from a plurality of interleaved data blocks, the interleaved data blocks being generated from uninterleaved data blocks by means of an interleaving apparatus according to any of claims 28 to 53, the recovering apparatus comprising
a receiving means for receiving the plurality of interleaved data blocks (1201-1203) and the number of words within each of the uninterleaved data blocks;
a mapping unit (1000; 1100) for mapping each word of an interleaved data block to a distinct word of a frame block so as to define a frame block for each interleaved data block, the frame blocks having the predetermined size;
a deinterleaver for generating a plurality of uninterleaved data blocks, each uninterleaved data block consisting of words of a corresponding deinterleaved frame block, the deinterleaved frame blocks being defined by applying convolutional deinterleaving to the frame blocks defined in the mapping step,
wherein the mapping unit (1000; 1100) is adapted for mapping each word of an interleaved data block to a distinct word of a frame block in accordance with a distribution of words of data blocks to words of frame blocks generated by applying the interleaving method employed by the interleaving apparatus to data blocks having the received numbers of words.
